# FASCICULE DE BREVET EUROPEEN

(11) **EP 4 187 622 B1**
(45) Date de publication et mention de la délivrance du brevet: **03.04.2024**
(21) Numéro de dépôt: 22208450.1
(22) Date de dépôt: 20.11.2022
(51) Int. Cl.: H01L 33/00, H01L 31/105, H01S 5/042, H01S 5/12, H01S 5/32

(54) **DISPOSITIF OPTOÉLECTRONIQUE COMPORTANT UNE COUCHE SEMICONDUCTRICE À BASE DE GESN PRÉSENTANT UNE PORTION MONOCRISTALLINE À STRUCTURE DE BANDES DIRECTE ET UNE ZONE BARRIÈRE SOUS-JACENTE**
OPTOELEKTRONISCHE VORRICHTUNG MIT EINER GESN-HALBLEITERSCHICHT MIT EINEM EINKRISTALLINEN TEIL MIT DIREKTER BANDSTRUKTUR UND EINER DARUNTER LIEGENDEN SPERRZONE
OPTOELECTRONIC DEVICE COMPRISING A SEMICONDUCTOR LAYER BASED ON GESN AND HAVING A MONOCRYSTALLINE PORTION WITH A DIRECT STRIP STRUCTURE AND AN UNDERLYING BARRIER ZONE

(30) Priorité: 23.11.2021 FR 2112376
(43) Date de publication de la demande: 31.05.2023
(73) Titulaire: Commissariat à l'Energie Atomique et aux Energies Alternatives, 75015 Paris (FR)
(72) Inventeur: CASIEZ, Lara, 38054 Grenoble cedex 09 (FR); REBOUD, Vincent, 38054 Grenoble cedex 09 (FR); ACOSTA ALBA, Pablo, 38054 Grenoble cedex 09 (FR)
(74) Mandataire: Brevalex

(56) Documents cités:
- WO-A1-2018/037189
- WIRTHS S ET AL: "Lasing in direct-bandgap GeSn alloy grown on Si", NATURE PHOTONICS, NATURE PUBLISHING GROUP UK, LONDON, vol. 9, no. 2, 31 janvier 2015 (2015-01-31), pages 88-92, XP009514073, ISSN: 1749-4885, DOI: 10.1038/NPHOTON.2014.321
- GALLUCCIO EMMANUELE ET AL: "Cell formation in stanogermanides using pulsed laser thermal anneal on Ge0.91Sn0.09", MATERIALS SCIENCE IN SEMICONDUCTOR PROCESSING, ELSEVIER SCIENCE PUBLISHERS B.V., BARKING, UK, vol. 121, 26 août 2020 (2020-08-26), XP086329669, ISSN: 1369-8001, DOI: 10.1016/J.MSSP.2020.105399 [extrait le 2020-08-26]
- REBOUD V ET AL: "Lasing in Group-IV materials", ARXIV.ORG, CORNELL UNIVERSITY LIBRARY, 201 OLIN LIBRARY CORNELL UNIVERSITY ITHACA, NY 14853, 18 décembre 2020 (2020-12-18), XP081841232,
- CHANG GUO-EN ET AL: "Design and Analysis of Tensile-Strained GeSn Mid-Infrared Photodetectors on Silicon", 2019 IEEE 16TH INTERNATIONAL CONFERENCE ON GROUP IV PHOTONICS (GFP), IEEE, vol. 1949-209X, 28 août 2019 (2019-08-28), pages 1-2, XP033624030, DOI: 10.1109/GROUP4.2019.8853915

## Description

### DOMAINE TECHNIQUE

Le domaine de l'invention est celui des dispositifs optoélectroniques d'émission ou de réception d'un rayonnement infrarouge, et plus particulièrement d'un rayonnement du moyen infrarouge (MWIR, pour *Middle Wave InfraRed,* en anglais), comportant une couche semiconductrice à base de germanium étain GeSn dans laquelle se situe une jonction semiconductrice PIN.

### ÉTAT DE LA TECHNIQUE ANTÉRIEURE

Les dispositifs optoélectroniques d'émission d'un rayonnement infrarouge peuvent comporter une couche semiconductrice optiquement active réalisée à base d'un composé cristallin de la colonne IV du tableau périodique des éléments, par exemple un composé à base de germanium étain GeSn. La couche semiconductrice comporte une jonction semiconductrice, par exemple de type PIN, où est généré l'essentiel du rayonnement infrarouge émis par le dispositif optoélectronique. Le germanium étain Ge₁₋ₓSnₓ peut en effet présenter une structure de bandes d'énergie directe propice à l'émission du rayonnement lumineux infrarouge lorsque la proportion atomique d'étain x est suffisante.

La réalisation de telle couche semiconductrice à base de GeSn reste cependant délicate, du fait notamment de la différence importante entre le paramètre de maille du germanium (a_{Ge}=5,658Å) et celui de l'étain (a_{Sn}=6,489Å), et de la différence entre la température de fusion du germanium (950°C environ) et celle de l'étain (240°C environ) qui peut conduire à une démixtion de l'étain.

Pour fabriquer un tel dispositif optoélectronique, une approche consiste à réaliser une couche semiconductrice de GeSn partiellement relaxée par croissance épitaxiale, à partir d'un pseudo-substrat (*virtual-substrate,* en anglais) de germanium. A ce titre, la publication de Wirths et al. intitulée Lasing in direct-bandgap GeSn alloy grown on Si, Nature Photon. 9, 88-92 (2015) décrit un procédé de fabrication d'un dispositif optoélectronique dans lequel une couche semiconductrice en germanium étain GeSn est réalisée par croissance épitaxiale de type CVD à partir d'une couche de nucléation en germanium Ge quasi-relaxée formé sur un substrat de silicium Si. Une couche semiconductrice épaisse en germanium étain GeSn est formée par épitaxie à partir de la couche de nucléation, et présente une épaisseur suffisante pour que les contraintes mécaniques relaxent plastiquement et que le germanium étain, sur au moins une épaisseur de la couche semiconductrice, est quasi-relaxé. Aussi, la couche semiconductrice ainsi réalisée présente une relative bonne qualité cristalline, hormis à l'interface avec la couche de nucléation où la relaxation plastique des contraintes mécaniques a généré des défauts structuraux de type dislocations. Les auteurs montrent qu'une proportion atomique d'étain de 12,6% permet de rendre directe la structure de bandes d'énergie dans une couche semiconductrice de GeSn relaxé et ainsi d'émettre un rayonnement lumineux infrarouge. Cependant, il peut être nécessaire d'obtenir une couche semiconductrice à structure de bandes directe avec une proportion atomique d'étain plus faible.

Une autre approche consiste alors à réaliser une couche semiconductrice à base de GeSn subissant des contraintes mécaniques en tension dans le plan principal de la couche. En effet, comme le montre notamment la publication de Wirths et al. intitulée Strain Engineering for Direct Bandgap GeSn Alloys, IEEE 11th International Conférence On Group IV Photonics, 2014, la proportion atomique minimale xₘᵢₙ d'étain pour que la structure de bandes d'énergie de la couche semiconductrice soit directe dépend du type de contraintes mécaniques subies par la couche semiconductrice (compression ou tension) et de leur intensité. Aussi, la diminution de cette proportion atomique minimale xₘᵢₙ d'étain permet de réduire les risques de démixtion de l'étain.

A ce titre, la demande internationale WO2018/037189A1 décrit un procédé de fabrication d'un dispositif optoélectronique d'émission du rayonnement infrarouge dans une couche semiconductrice à base de GeSn contrainte en tension, celle-ci étant obtenue sous la forme d'une membrane suspendue au-dessus d'un substrat et mise en tension par des bras tenseurs, puis effondrée sur le substrat et assemblée à celui-ci par collage direct.

Ce dispositif optoélectronique comporte donc une couche semiconductrice à base de GeSn, dans laquelle se situe une jonction semiconductrice PIN affleurant la face supérieure. Des contacts métalliques de polarisation reposent sur et au contact d'une région dopée de type n et d'une région dopée de type p. La région intrinsèque est située dans une portion de la couche semiconductrice présentant une contrainte en tension, et où la proportion atomique moyenne d'étain est suffisante pour que, compte tenu de la valeur de la contrainte en tension, la structure de bandes d'énergie y soit directe.

Cependant, il existe un besoin de disposer d'un dispositif optoélectronique d'émission ou de réception d'un rayonnement infrarouge, comportant une couche semiconductrice à base de GeSn contrainte en tension et ayant une proportion atomique d'étain suffisante pour que la structure de bandes y soit directe, pouvant être fabriqué sans avoir recours au procédé de mise en tension par réalisation d'une membrane suspendue suivie de son effondrement, ni à des techniques d'ingénierie de la contrainte mécanique par réalisation d'un empilement de couches minces.

### EXPOSÉ DE L'INVENTION

L'invention a pour objectif de remédier au moins en partie aux inconvénients de l'art antérieur, et plus particulièrement de proposer un dispositif optoélectronique d'émission ou de réception d'un rayonnement infrarouge, comportant une couche semiconductrice à base de GeSn contrainte en tension et ayant une proportion atomique d'étain suffisante pour que la structure de bandes y soit directe, qui présente de bonnes performances, et qui puisse être réalisé sans avoir recours aux procédés cités précédemment, en particulier au procédé décrit dans la demande internationale WO2018/037189A1.

Pour cela, l'objet de l'invention est un dispositif optoélectronique d'émission ou de réception d'un rayonnement infrarouge, comportant : une couche de nucléation ; une couche semiconductrice cristalline à base de GeSn ; et des contacts métalliques de polarisation, situés sur et au contact de régions dopées. La couche semiconductrice s'étend suivant un plan principal, présente une face supérieure opposée à la couche de nucléation, et comporte : une portion de base, s'étendant sur et au contact de la couche de nucléation ; une portion supérieure, s'étendant sur la portion de base, monocristalline, et contrainte en tension d'une valeur moyenne εₚₛ dans le plan principal, formée d'un milieu homogène, présentant une valeur homogène xₚₛ₁ de proportion atomique d'étain, la valeur moyenne εₚₛ des contraintes en tension et la valeur xₚₛ₁ de la proportion atomique d'étain étant telles que la portion supérieure présente une structure de bandes interdites directe ; une jonction semiconductrice PIN, comportant une région dopée de type n, et une région dopée de type p, affleurant la face supérieure, et une région intrinsèque, située dans la portion supérieure, et s'étendant entre les régions dopées.

Selon l'invention, la portion supérieure monocristalline comporte, outre le milieu homogène, des structures verticales s'étendant dans le milieu homogène suivant un axe orthogonal au plan principal sur toute l'épaisseur de la portion supérieure, et présentant une valeur moyenne xₚₛ₂ de proportion atomique d'étain supérieure à xₚₛ₁, formant ainsi des zones d'émission ou de réception du rayonnement infrarouge.

De plus, la couche semiconductrice comporte en outre une portion intermédiaire, située entre et au contact de la portion de base et la portion supérieure suivant un axe orthogonal au plan principal, monocristalline, et comportant une zone s'étendant dans le plan principal sur toute sa largeur et présentant une valeur moyenne xₚᵢ₁ de proportion atomique d'étain inférieure à xₚₛ₁, formant ainsi une zone barrière vis-à-vis de porteurs de charge circulant dans la portion supérieure.

Certains aspects préférés mais non limitatifs de ce dispositif optoélectronique sont les suivants.

La portion de base peut présenter une valeur moyenne x_{pb} supérieure à la valeur moyenne xₚᵢ₁ de la proportion atomique d'étain dans la portion intermédiaire et inférieure à la valeur moyenne xₚₛ₂ de la proportion atomique d'étain dans les structures verticales.

La valeur moyenne x_{pb} de la proportion atomique d'étain dans la portion de base peut être comprise entre 4% et 10%.

La portion de base peut s'étendre jusqu'à une surface de la face supérieure (10a), et entourer la portion intermédiaire et la portion supérieure dans le plan principal, au moins l'une des régions dopées étant situées dans la portion de base.

La portion intermédiaire peut recouvrir entièrement la portion de base, les régions dopées étant situées dans la portion supérieure.

La couche semiconductrice peut être formée, à partir de la couche de nucléation, d'une zone inférieure et d'une zone supérieure monocristalline, la portion supérieure étant située dans la zone supérieure.

La couche de nucléation peut être réalisée en germanium, et peut reposer sur un substrat support de préférence à base de silicium.

Le dispositif optoélectronique peut être une diode laser ou une diode électroluminescente adaptée à générer le rayonnement infrarouge, ou une photodiode adaptée à détecter le rayonnement infrarouge.

Le dispositif optoélectronique peut former une diode laser, et comporter un guide d'onde dit inférieur réalisé dans la couche de nucléation à base de germanium, un guide d'onde dit actif couplé au guide d'onde inférieur, comportant le milieu à gain et réalisé dans la couche semiconductrice, et au moins un réflecteur de Bragg situé dans le guide d'onde inférieur ou dans le guide d'onde actif.

L'invention porte également sur un procédé de fabrication d'un dispositif optoélectronique selon l'une quelconque des caractéristiques précédentes, comportant les étapes suivantes : réalisation de la couche semiconductrice présentant une valeur initiale homogène de la proportion atomique d'étain, égale à la valeur moyenne x_{pb} de la portion de base, par épitaxie à partir de la couche de nucléation ; réalisation des régions dopées dans la couche semiconductrice, espacées l'une de l'autre par la région intrinsèque ; réalisation de la portion intermédiaire et de la portion supérieure, par recuit par laser nanoseconde, en appliquant une impulsion laser sur au moins une surface de la face supérieure où affleure la région intrinsèque, présentant une longueur d'onde, une densité d'énergie et une durée prédéfinies de manière à faire fondre entièrement une partie du composé de la couche semiconductrice sur une profondeur prédéfinie de celle-ci, de préférence au moins égale à 150nm.

L'étape de recuit par laser nanoseconde peut être effectuée en éclairant par l'impulsion laser seulement la surface de la face supérieure où affleure la région intrinsèque.

L'étape de recuit par laser nanoseconde peut être effectuée en éclairant par l'impulsion laser la face supérieure de la couche semiconductrice où se situe la jonction semiconductrice PIN.

Le procédé de fabrication peut comporter, préalablement à l'étape de recuit par laser nanoseconde, une étape d'amorphisation d'au moins la région intrinsèque par implantation ionique d'élément chimiques non dopants de type n ou p, sur une profondeur au moins égale à la profondeur des régions dopées.

Seule la région intrinsèque peut être amorphisée lors de l'étape d'amorphisation, avant l'étape de recuit par laser nanoseconde.

L'étape de réalisation des régions dopées peut être effectuée de manière à amorphiser les régions dopées.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

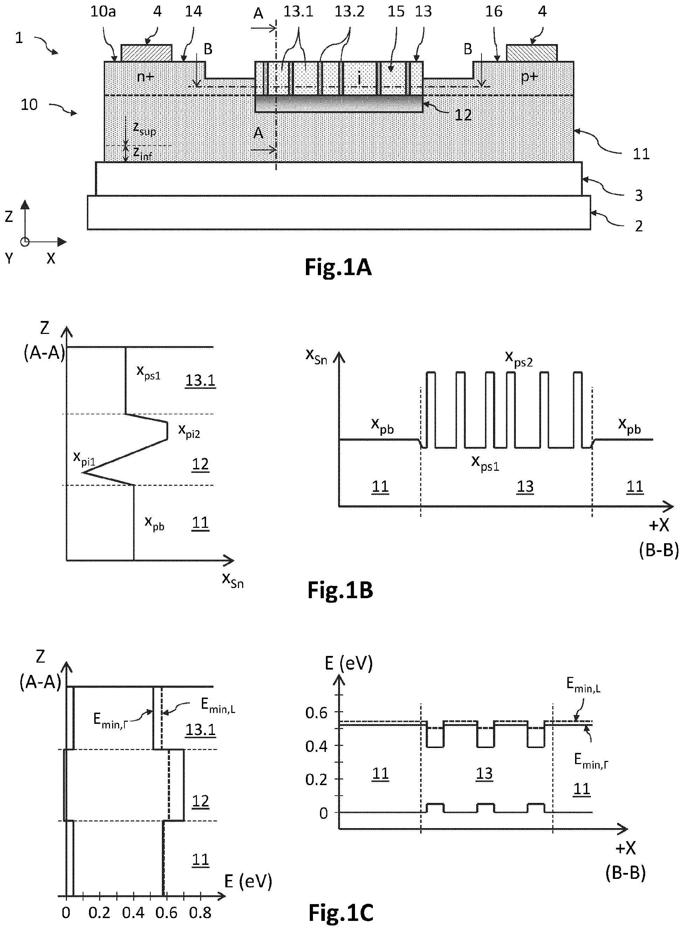

la figure 1A est une vue schématique et partielle, en coupe transversale, d'un dispositif optoélectronique selon un mode de réalisation ;
La figure 1B illustre des exemples d'évolution de la proportion atomique d'étain dans le dispositif optoélectronique de la fig. 1A, suivant la ligne de coupe A-A (graphe de gauche) et suivant la ligne de coupe B-B (graphe de droite) ;
La figure 1B illustre des exemples de structure de bandes d'énergie dans le dispositif optoélectronique de la fig. 1A, suivant la ligne de coupe A-A (graphe de gauche) et suivant la ligne de coupe B-B (graphe de droite) ;
La figure 2A illustre des vues en coupe, obtenues par microscopie électronique en transmission à balayage, d'un exemple d'empilement du dispositif optoélectronique de la fig.1A, formé du substrat support en silicium, de la couche de nucléation en germanium, et de la couche semiconductrice en GeSn, mettant en évidence la portion de base, la portion intermédiaire, et la portion supérieure ;
La figure 2B illustre une vue de dessus, obtenue par microscopie électronique, d'un exemple de la surface de la portion supérieure de la couche semiconductrice du dispositif optoélectronique de la fig. 1A, mettant en évidence le milieu homogène et les structures verticales de la portion supérieure ;
Les figures 3A à 3H illustrent des étapes d'un procédé de fabrication d'un dispositif optoélectronique selon un mode de réalisation similaire à celui de la fig. 1A ;
Les figures 4A et 4B sont des vues schématiques et partielles, en coupe transversale, d'un dispositif optoélectronique selon des variantes de réalisation.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un dispositif optoélectronique d'émission ou de réception d'un rayonnement infrarouge, par exemple une diode laser, une diode électroluminescente, ou une photodiode. Le rayonnement infrarouge émis ou reçu est situé dans la gamme spectrale infrarouge, et plus précisément dans la gamme spectrale du moyen infrarouge (longueur d'onde centrale λ comprise de préférence entre 2µm et 6µm environ).

Le dispositif optoélectronique comporte une couche semiconductrice à base de germanium étain GeSn qui comporte plusieurs zones ou portions qui se distinguent les unes des autres notamment par la proportion atomique d'étain. Elle comporte en particulier une portion supérieure contrainte en tension et où la proportion atomique d'étain x est suffisante pour que, compte tenu des contraintes en tension, la structure de bandes d'énergie y soit directe.

Par couche semiconductrice à base de germanium étain GeSn, on entend une couche réalisée en un composé semiconducteur comprenant au moins du germanium Ge et de l'étain Sn. Le composé semiconducteur à base de GeSn peut être un composé binaire Ge₁₋ₓSnₓ, un composé ternaire, par exemple Si_{y}Ge_{1-x-y}Snₓ, voire un composé quaternaire ou plus. On note x la proportion atomique locale ou moyenne d'étain contenu dans le composé semiconducteur.

Par portion contrainte, on entend une portion de la couche semiconductrice présentant une contrainte mécanique en tension ou en compression, entraînant une déformation des mailles de son réseau cristallin. La portion est contrainte en tension lorsqu'elle subit une contrainte mécanique qui tend à étirer les mailles du réseau dans un plan. Dans le cadre de l'invention, la portion supérieure de la couche semiconductrice est contrainte en tension dans le plan principal de la couche, ce qui se traduit par le fait que son paramètre de maille présente une valeur effective supérieure à sa valeur naturelle lorsque le composé semiconducteur est relaxé (i.e. non contraint). Dans la suite de la description, la contrainte considérée est orientée dans le plan principal de la couche semiconductrice.

Le composé à base de GeSn de la couche semiconductrice présente une structure de bandes d'énergie indirecte en l'absence de contraintes en tension suffisantes et/ou d'une proportion atomique d'étain suffisante. Les contraintes en tension subies dans la portion supérieure et la proportion atomique d'étain y sont suffisantes pour que sa structure de bandes d'énergie soit directe. D'une manière générale, le GeSn présente une structure de bandes d'énergie directe lorsque le minimum d'énergie de la vallée L (ou vallée indirecte) est supérieur ou égal au minimum d'énergie de la vallée Γ (ou vallée directe) de la bande de conduction, autrement dit : ΔE = E_{min,L}-E_{min,Γ} ≥ 0. Par égal, on entend ici que cette différence d'énergie ΔE est de l'ordre de grandeur ou inférieure à kT, où k est la constante de Boltzmann et T la température du matériau. Comme l'a montré Wirths et al. 2014 mentionné précédemment, la proportion atomique minimale d'étain xₘᵢₙ pour rendre directe la structure de bandes d'énergie diminue à mesure qu'augmentent les contraintes mécaniques en tension subies par la couche semiconductrice.

Dans le cadre de l'invention, la couche semiconductrice à base de germanium étain GeSn comporte une portion de base, une portion intermédiaire et une portion supérieure, où ces deux dernières sont agencées verticalement l'une au-dessus de l'autre suivant l'axe d'épaisseur de la couche semiconductrice. La portion supérieure présente une structure de bandes d'énergie directe. De plus, elle est monocristalline et est formée d'un milieu homogène dans lequel s'étendent des structures verticales formant des puits quantiques (zones d'émission ou de réception du rayonnement infrarouge). Par ailleurs, la portion intermédiaire, située sous la portion supérieure, forme une zone barrière pour les porteurs de charge circulant dans la portion supérieure.

La figure 1A est une vue partielle et schématique, en coupe transversale, d'un dispositif optoélectronique 1 selon un mode de réalisation. Le dispositif optoélectronique 1 est ici adapté à émettre un rayonnement lumineux cohérent (diode laser), et peut être de type à rétroaction distribuée (DFB pour *Distributed Feedback,* en anglais) ou de type à réflecteur de Bragg distribué (DBR pour *Distributed Bragg Reflector,* en anglais).

On définit ici et pour la suite de la description un repère direct tridimensionnel XYZ, où les axes X et Y forment un plan parallèle au plan principal d'un substrat support 2 sur lequel repose la couche semiconductrice 10, et où l'axe Z est orienté suivant l'épaisseur des couches. Dans la suite de la description, les termes « vertical » et « verticalement » s'entendent comme étant relatifs à une orientation sensiblement parallèle à l'axe Z. Par ailleurs, les termes « inférieur » et « supérieur » s'entendent comme étant relatifs à un positionnement croissant lorsqu'on s'éloigne du substrat support 2 suivant la direction +Z.

Le dispositif optoélectronique 1 comporte une couche semiconductrice 10 à base de GeSn épitaxiée à partir d'une couche de nucléation 3, laquelle repose sur un substrat support 2. La couche semiconductrice 10 présente une face supérieure 10a opposée à la couche de nucléation 3, où affleure au moins une région dopée 14 de type n et une région 16 dopée de type p d'une jonction semiconductrice PIN.

Le dispositif optoélectronique 1 comporte ici un substrat support 2, réalisé en un matériau électriquement conducteur ou diélectrique. Ce substrat support 2 peut présenter une épaisseur de l'ordre de quelques dizaines de nanomètres à quelques centaines de microns, par exemple une épaisseur comprise entre 10µm et 750µm. Il est réalisé ici en silicium, mais peut plus généralement être réalisé en saphir, borosilicate, silice, verre, quartz, entre autres.

Le dispositif optoélectronique 1 comporte une couche de nucléation 3 réalisée sur le substrat support 2. En variante, le substrat support 2 et la couche de nucléation 3 peuvent être des zones d'un même substrat ou d'une même couche. La couche de nucléation 3 est réalisée en un matériau cristallin adapté à la nucléation (germination) de la couche semiconductrice 10 à base de GeSn. Le matériau est monocristallin au moins au niveau de la face supérieure (opposée au substrat support 2) de la couche de nucléation 3. Il peut être choisi parmi les éléments ou composés de la colonne IV du tableau de classification périodique, et peut être du germanium comme ici, voire du silicium, de l'étain, ou les composés tels que le GeSn, SiGeSn, SiGe. Il peut également être choisi parmi les composés des colonnes III et IV, tels que le GaP, AlP, AlAs, InP, etc... ou encore peut être choisi parmi les composés des colonnes II et VI, tels que le ZnS, CdTe, etc... Dans cet exemple, la couche de nucléation 3 est une couche de germanium présentant une épaisseur supérieure à l'épaisseur critique à partir de laquelle les contraintes mécaniques subies par la couche relaxent de manière plastique.

Le dispositif optoélectronique 1 comporte une couche semiconductrice 10 à base de GeSn, réalisée par épitaxie à partir de la couche de nucléation 3. Elle est réalisée en un composé semiconducteur cristallin à base de GeSn, c'est-à-dire en le composé binaire GeSn comme ici, ou en variante en ses composés ternaires (SiGeSn...) voire quaternaires par exemple.

La couche semiconductrice 10 présente une épaisseur supérieure à l'épaisseur critique à partir de laquelle les contraintes mécaniques subies par la couche relaxent de manière plastique. Ainsi, l'épaisseur de la couche semiconductrice 10 peut être au moins égale à 300nm, et par exemple comprise entre 300nm et 2µm. A titre d'exemple, elle est ici égale à 480nm.

Aussi, la couche semiconductrice 10 est mono cristalline sur une large partie de son épaisseur, en particulier là où se situe notamment la jonction semiconductrice PIN. Autrement dit, elle présente une zone inférieure z_{inf} s'étendant suivant l'axe Z à partir de la couche de nucléation 3 en germanium, et où des défauts structuraux de type dislocations peuvent être présents ; puis une zone supérieure zₛᵤₚ qui ne comporte sensiblement pas de défauts structuraux et donc monocristalline. Cette zone supérieure zₛᵤₚ s'étend à partir de la zone inférieure z_{inf} jusqu'à la face supérieure 10a de la couche semiconductrice 10. La jonction semiconductrice PIN est située dans cette zone supérieure zₛᵤₚ monocristalline.

Le composé semiconducteur Ge₁₋ₓSnₓ présente une proportion atomique d'étain x qui n'est pas homogène partout dans la couche semiconductrice 10. Ainsi, elle peut être homogène dans certaines zones ou portions de la couche semiconductrice 10, par exemple dans 1a portion de base 11, et varier verticalement (suivant l'axe d'épaisseur Z) et/ou horizontalement (dans le plan XY) dans certaines zones ou portions de la couche semiconductrice 10, par exemple dans les portions intermédiaire 12 et supérieure 13.

De plus, la couche semiconductrice 10 présente des contraintes mécaniques orientées dans le plan XY qui ne sont pas non plus homogènes partout. Ainsi, elle peut présenter des contraintes mécaniques en compression dans certaines zones ou portions, et elle présente des contraintes en tension dans d'autres zones ou portions, en particulier dans 1a portion supérieure 13. On note ε la valeur locale ou moyenne des contraintes mécaniques subies dans le plan XY, de signe positif (contraintes en compression) ou négatif (contraintes en tension).

La couche semiconductrice 10 comporte en particulier plusieurs portions qui se distinguent par leur proportion atomique moyenne d'étain et/ou par les contraintes mécaniques moyennes qu'elles subissent. Par proportion moyenne ou contrainte moyenne, on entend ici la valeur moyenne dans l'ensemble du milieu considéré. Ainsi, la couche semiconductrice 10 comporte une portion de base 11 qui s'étend sur et au contact de la couche de nucléation 3 ; une portion intermédiaire 12 qui s'étend sur et au contact de la portion de base 11 ; et une portion supérieure 13 qui s'étend sur et au contact de la portion intermédiaire 12. Par « s'étendre sur », on entend que la portion est située au-dessus de la portion sous-jacente suivant l'axe Z.

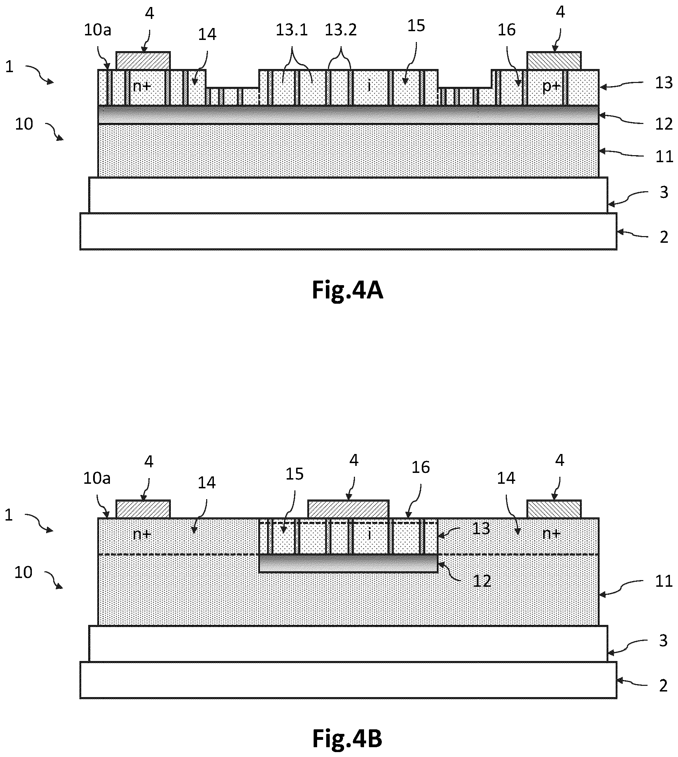

Dans ce mode de réalisation, la portion de base 11 s'étend à partir de la couche de nucléation 3 jusqu'à la face supérieure 10a de la couche semiconductrice 10, et entoure donc la portion intermédiaire 12 et la portion supérieure 13 dans le plan XY. En variante, comme décrit en détail en référence à la fig.4A, la portion de base 11 peut ne s'étendre que sur une partie de l'épaisseur de la couche semiconductrice 10 et être donc recouverte par la portion intermédiaire 12 et la portion supérieure 13.

La couche semiconductrice 10 comporte tout d'abord une portion de base 11, qui s'étend sur et au contact de la couche de nucléation 3. La portion de base 11 s'étend dans la zone inférieure (où elle peut comporter des défauts structuraux) et donc à partir de la couche de nucléation 3, et ici dans la zone supérieure et y est donc monocristalline. La portion de base 11 présente une proportion atomique d'étain sensiblement homogène, égale à une valeur moyenne x_{pb}. La proportion atomique moyenne d'étain x_{pb} peut être comprise entre 4% et 20%, et de préférence entre 4% et 10% (donc avec une portion de base 11 présentant un gap indirect), et est ici égale à 8% environ. Elle peut présenter des contraintes mécaniques non nulles, par exemple des contraintes en compression dans la zone inférieure z_{inf}, ou être relaxée ou quasi-relaxée en particulier dans la zone supérieure zₛᵤₚ. Elle peut également être contrainte en compression dans ton son volume (i.e. dans les zones inférieure z_{inf} et supérieure zₛᵤₚ).

La couche semiconductrice 10 comporte ensuite la portion intermédiaire 12, qui s'étend entre (suivant l'axe Z) et au contact de la portion de base 11 et la portion supérieure 13. Dans cet exemple, elle ne s'étend pas sur toute la largeur de la couche semiconductrice 10, et est donc entourée par la portion de base 11 dans le plan XY. Dans cet exemple, la portion supérieure présente une épaisseur égale à 75nm environ.

La portion intermédiaire 12 est située dans la zone supérieure zₛᵤₚ, et est donc monocristalline. Par ailleurs, elle présente une proportion atomique d'étain xₚᵢ qui varie suivant l'axe Z, et reste ici sensiblement constante dans le plan XY. La proportion atomique d'étain xₚᵢ présente en particulier une valeur minimale xₚᵢ₁ inférieure à une valeur xₚₛ₁ d'un milieu homogène 13.1 (présenté plus loin) de la portion supérieure 13. Dans cet exemple, elle varie entre la valeur minimale xₚᵢ₁ et une valeur maximale xₚᵢ₂ supérieure à xₚᵢ₁. A titre d'exemple, dans le cas où la proportion atomique moyenne d'étain x_{pb} est égale à 8% environ, la valeur minimale xₚᵢ₁ est égale à 2% environ, et la valeur maximale xₚᵢ₂ est égale à 10% environ.

La couche semiconductrice 10 comporte enfin la portion supérieure 13, qui s'étend sur et au contact de la portion intermédiaire 12. Plus précisément, elle repose entièrement sur la portion intermédiaire 12. Dans cet exemple, elle ne s'étend pas sur toute la largeur de la couche semiconductrice 10, et est donc entourée par la portion de base 11 dans le plan XY. Dans cet exemple, la portion supérieure présente une épaisseur égale à 135nm environ.

La portion supérieure 13 est située dans la zone supérieure zₛᵤₚ, et est donc monocristalline. Par ailleurs, elle présente une proportion atomique d'étain xₚₛ qui varie dans le plan XY. Plus précisément, la portion supérieure 13 est formée d'un milieu homogène 13.1 dont la proportion atomique d'étain est homogène et égale à une valeur moyenne xₚₛ₁ supérieure à la valeur minimale xₚᵢ₁ de la portion intermédiaire 12 ; et de structures verticales 13.2 dont la proportion atomique d'étain moyenne xₚₛ₂ est supérieure à la valeur xₚₛ₁ du milieu homogène 13.1. Dans cet exemple, la proportion atomique d'étain xₚₛ₁ du milieu homogène est égal à 7% environ, et la proportion atomique d'étain xₚₛ₂ des structures verticales est égale à 16% environ, bien supérieure à la valeur moyenne x_{pb} de la portion de base. Précisons que la portion supérieure 13 est monocristalline malgré la présence des structures verticales 13.2.

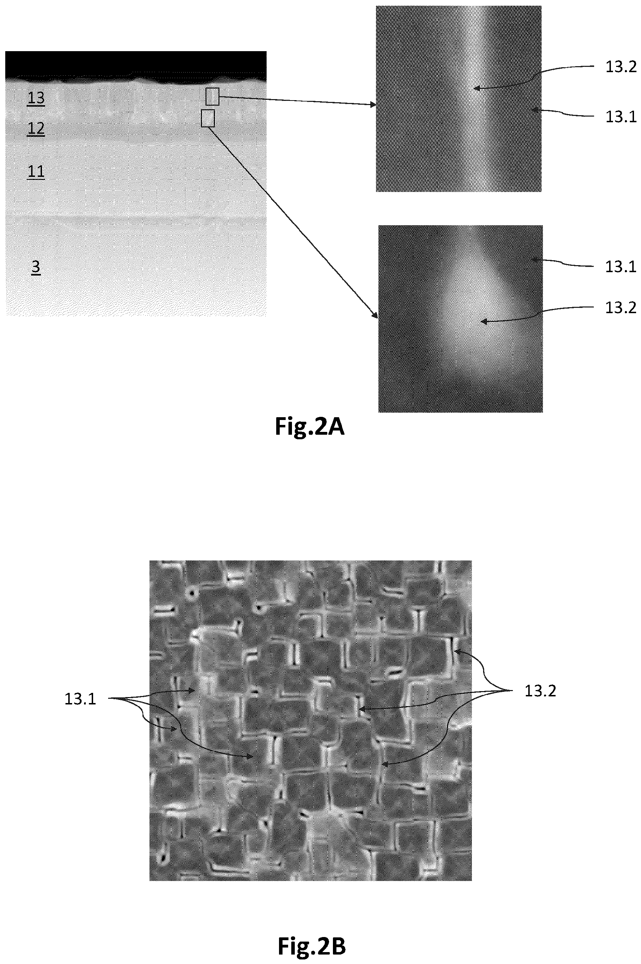

Les structures verticales 13.2 s'étendent sur toute l'épaisseur de la portion supérieure 13, suivant un axe sensiblement parallèle à l'axe Z. Elles présentent alors une hauteur suivant l'axe Z sensiblement égale à l'épaisseur de la portion supérieure 13. Elles peuvent présenter une forme colonnaire dans le sens où les deux dimensions transversales dans le plan XY sont du même ordre, ou présenter une forme de paroi dans le sens où l'une des dimensions transversales dans le plan XY (longueur) est supérieure, par exemple au moins 5 ou 10 fois supérieure, à l'autre des dimensions transversales (largeur), comme l'illustre la fig.2B. Cette forme de paroi des structures verticales 13.2 permet d'abaisser le seuil laser par rapport à des colonnes, dans la mesure où les porteurs de charge ont plus de chance de se recombiner dans les puits quantiques. Par ailleurs, les dimensions transversales dans le plan XY peuvent être constantes ou non suivant toute ou partie de leur hauteur.

Par ailleurs, la portion supérieure 13 présente des contraintes mécaniques en tension dans le plan XY, d'une valeur moyenne εₚₛ. A titre d'exemple, les contraintes mécaniques εₚₛ sont ici égales à -0.4% environ. La valeur moyenne εₚₛ des contraintes en tension de la portion supérieure 13 et la valeur moyenne xₚₛ₁ de la proportion atomique d'étain du milieu homogène 13.1 se traduisent par le fait que la structure de bandes d'énergie est directe dans les structures verticales 13.2, et ici dans toute la portion supérieure 13 (donc aussi dans le milieu homogène 13.1). Notons ici que la mise en tension de la portion supérieure 13 peut être due à la présence des structures verticales 13.2 dans le milieu homogène 13.1, et/ou peut être due au fait que la proportion atomique d'étain du milieu homogène 13.1 est inférieure à celle de la portion de base 11, voire encore peut être due à la zone enrichie en étain et de proportion xₚᵢ₂ dans la portion intermédiaire 12.

La couche semiconductrice 10 comporte une jonction semiconductrice PIN située dans la zone supérieure zₛᵤₚ, et plus précisément une région 14 dopée de type n et une région 16 dopée de type p qui affleurent la face supérieure 10a, entre lesquelles s'étend une région intrinsèque 15 (non intentionnellement dopée par des éléments dopants). Le niveau de dopage des régions dopées 14, 16 peut être par exemple compris entre 5×10¹⁸ cm⁻³ et 1×10²⁰ cm⁻³, et peut ici être égal à 3×10¹⁹ cm⁻³ environ. Dans cet exemple, la région 14 dopée n+ et la région 16 dopée p+ sont situées dans la portion de base 11, de part et d'autre de la portion supérieure 13. La région intrinsèque 15 est située dans la portion supérieure 13, c'est-à-dire dans le milieu homogène 13.1 et dans les structures verticales 13.2.

Enfin, le dispositif optoélectronique 1 comporte des contacts métalliques 4 qui reposent sur la face supérieure 10a de la couche semiconductrice 10, l'un au contact de la région 14 dopée n+ et l'autre au contact de la région 16 dopée p+. Elles assurent la polarisation électrique de la jonction semiconductrice PIN.

En fonctionnement, le dispositif optoélectronique 1 est polarisé en direct par les contacts métalliques 4. Les porteurs de charge sont introduits dans la région 14 dopée n+ et dans la région 16 dopée p+, rejoignent la région intrinsèque 15, traversent le milieu homogène 13.1 et se recombinent dans les structures verticales 13.2. En effet, il apparaît que les structures verticales 13.2 dont la proportion atomique d'étain est xₚₛ₂ (ici par ex. 16%) entourées par le milieu homogène 13.1 à xₚₛ₁ (ici égale à 7% environ) inférieure à xₚₛ₂ forment des puits quantiques entourés par une barrière de potentiel, dans une portion supérieure 13 où la structure de bandes est directe. De plus, le taux de recombinaisons radiatives dans la région intrinsèque 15 est amélioré par le fait que la portion intermédiaire 12 avec sa proportion atomique d'étain à xₚᵢ₁ (ici égale à 2% environ) inférieure à xₚₛ₁ (ici égale à 7% environ) forme une zone barrière pour les porteurs de charge circulant dans la région intrinsèque 15. Par ailleurs, les performances du dispositif optoélectronique 1 sont améliorées par le fait que la région intrinsèque 15 avec ses structures verticales 13.2 est située dans une portion supérieure 13 mono cristalline déformée en tension.

La figure 1B illustre un exemple d'évolutions de la proportion atomique d'étain dans la couche semiconductrice 10, et la figure 1C illustre un exemple de structures de bandes d'énergie dans la couche semiconductrice 10, selon les lignes de coupe A-A (graphes de gauche) et B-B (graphes de droite) représentées sur la fig.1A.

Considérons tout d'abord la ligne de coupe B-B (graphes de droite des fig.1B et 1C). La proportion atomique d'étain passe de la valeur moyenne x_{pb} dans la portion de base 11, ici égale à 8% environ, à la valeur xₚₛ₁ dans le milieu homogène 13.1 de la portion supérieure 13, ici égale à 7% environ, et à la valeur xₚₛ₂ supérieure à xₚₛ₁ dans les structures verticales 13.2, ici égale à 16% environ.

Par ailleurs, la valeur moyenne εₚₛ des contraintes en tension dans la portion supérieure 13, par exemple ici égale à -0.4% environ, associée à la valeur xₚₛ₁ de la proportion atomique d'étain dans le milieu homogène 13.1, conduisent à ce que la structure de bandes d'énergie est directe. Ainsi, le minimum d'énergie E_{min,L} de la bande de conduction de la vallée L (trait en pointillé) est supérieur au minimum d'énergie E_{min,Γ} de la bande de conduction de la vallée Γ (trait continu). De plus, les structures verticales 13.2 de proportion atomique d'étain xₚₓ₂ entourées du milieu homogène 13.1 de proportion atomique d'étain xₚₛ₁ inférieure à xₚₛ₂ conduisent à ce que la structure de bandes d'énergie associée forme des puits quantiques entourés d'une barrière de potentiel. Aussi, les structures verticales 13.2 sont des zones de recombinaison radiatives des porteurs de charges injectés par les contacts métalliques, générant ainsi le rayonnement infrarouge.

Considérons maintenant la ligne de coupe A-A (graphes de gauche des fig. 1B et 1C). Dans la portion de base 11, la proportion atomique d'étain présente une valeur égale à x_{pb}, ici égale à 8% environ, qui reste sensiblement constante suivant l'axe Z. Dans la portion intermédiaire 12, la proportion atomique d'étain x chute de la valeur x_{pb} jusqu'à une valeur minimale xₚᵢ₁, ici égale à 2% environ, puis, dans cet exemple, remonte jusqu'à une valeur maximale xₚᵢ₂, ici égale à 10% environ. Enfin, la proportion atomique d'étain diminue jusqu'à la valeur xₚₛ, ici égale à 7% environ, qui reste sensiblement constante suivant l'axe Z dans la portion supérieure 13.

Dans le graphe du bas, par souci de clarté, la structure de bandes ne tient pas compte de la zone de la portion intermédiaire 12 à 10% d'étain. Le fait que la portion intermédiaire 12 présente une proportion atomique d'étain xₚᵢ₁ inférieure à xₚₛ (ici xₚᵢ₁=2% inférieure à xₚₛ=7%), se traduit par le fait que cette zone appauvrie en étain de la portion intermédiaire 12 forme une zone barrière pour les porteurs de charge circulant dans la portion supérieure 13, et donc circulant uniquement dans la région intrinsèque 15 de la jonction semiconductrice PIN. Il en résulte une amélioration du taux de recombinaison radiative dans la région intrinsèque 15, et donc une amélioration des performances du dispositif optoélectronique 1.

La figure 2A illustre des vues en coupe d'un exemple expérimental d'une couche semiconductrice 10 en GeSn reposant sur une couche de nucléation 3 en germanium d'un dispositif optoélectronique 1 selon un mode de réalisation.

On représente ici plus précisément la couche de nucléation 3 en germanium, puis la portion de base 11, la portion intermédiaire 12 et la portion supérieure 13 de la couche semiconductrice 10 de GeSn, ainsi que deux vues localisées d'une structure verticale 13.2, au niveau de sa racine et de son sommet. Les vues sont réalisées par microscopie électronique en transmission à balayage (STEM pour *Scanning Transmission Electron Microscopy* en anglais).

Dans cet exemple, la portion de base 11 est réalisée en GeSn avec une proportion atomique d'étain x_{pb} homogène de 8% environ. La portion intermédiaire 12 présente une proportion d'étain xₚᵢ qui passe de la valeur x_{pb} de 8% à une valeur minimale xₚᵢ₁ de 2% environ pour remonter jusqu'à une valeur maximale xₚᵢ₂ de 10% environ, et enfin redescendre à la valeur xₚₛ₁ de 7% environ. La portion supérieure 13 est formée du milieu homogène 13.1 où la proportion d'étain xₚₛ₁ est homogène et égale à 7% environ, et de structures verticales 13.2 où la proportion d'étain xₚₛ₂ est égale à 16% environ.

La figure 2B est une vue de dessus d'un exemple expérimental de portion supérieure 13 formée du milieu homogène 13.1 et des structures verticales 13.2. Cette vue de la surface est réalisée par microscopie électronique à balayage, et présente les structures verticales 13.2 dans la milieu homogène 13.1.

Il apparaît des fig.2A et 2B que les structures verticales 13.2 présentent ici une racine ayant des dimensions transversales (dans le plan XY) plus grandes que dans sa partie supérieure. De plus, la partie supérieure présente ici des dimensions transversales qui restent sensiblement constantes suivant l'axe Z. Enfin, les structures verticales 13.2 ont ici une forme de mur, dans le sens où elles présentent, dans le plan XY, une longueur plus importante que sa largeur, et s'étendent de manière à entourer au moins en partie une zone ou cellule du milieu homogène 13.1.

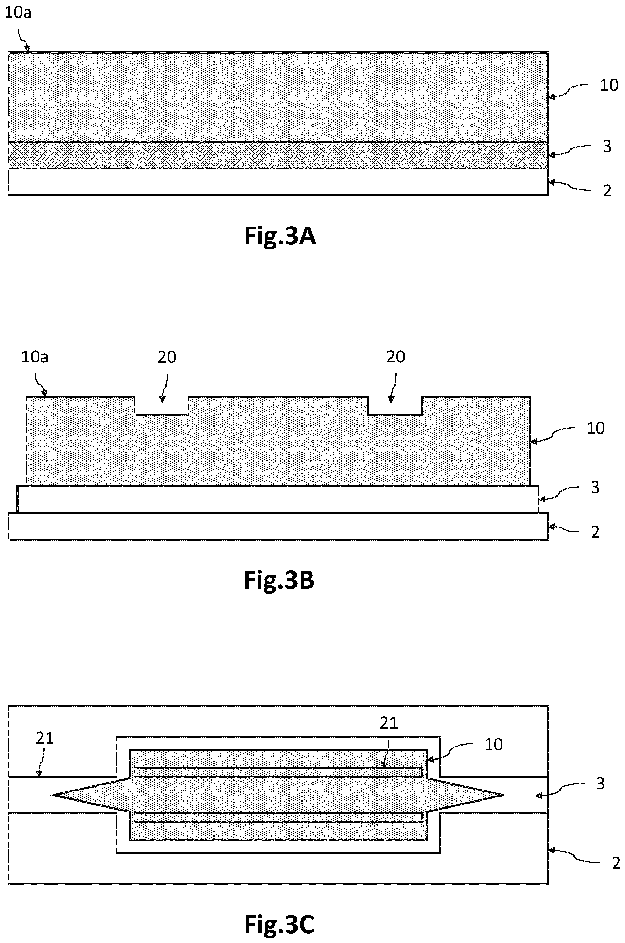

Les figures 3A à 3G illustrent différentes étapes d'un procédé de fabrication du dispositif optoélectronique 1 de la fig. 1A, selon un mode de réalisation. Dans cet exemple, le dispositif optoélectronique 1 est une diode laser. Le procédé met en oeuvre une étape de recuit par laser nanoseconde permettant de réaliser les portions intermédiaire 12 et supérieure 13, l'impulsion laser étant ici localisée sur une partie seulement de la face supérieure 10a. En variante, comme indiqué plus loin, elle peut éclairer toute la face supérieure 10a.

En référence à la fig.3A, on réalise un empilement formé du substrat support 2, de la couche de nucléation 3, et de la couche semiconductrice 10 à base de GeSn. Le substrat support 2 est ici une plaque (*wafer* en anglais) en silicium, et la couche de nucléation 3 est réalisée en germanium par épitaxie à partir du substrat support 2. La couche de nucléation 3 présente une épaisseur supérieure à son épaisseur critique, de sorte qu'elle est mono cristalline au niveau de sa face supérieure.

La couche semiconductrice 10 est réalisée ici en Ge₁₋ₓSnₓ avec ici x homogène et égal à ce qui sera la proportion atomique moyenne d'étain x_{pb} de la portion de base 11, ici égal à 8% environ. Elle peut être formée par des techniques de dépôt chimique en phase vapeur (CVD, pour *Chemical Vapor Deposition* en anglais), telles que le dépôt chimique à basse pression (RPCVD, pour *Reduce Pressure Chemical Vapor Déposition),* le dépôt chimique en phase vapeur organométallique (MOCVD, pour *Metal-Organic Chemical Vapor Deposition*)*,* le dépôt chimique en phase vapeur assisté par plasma (PECVD, pour *Plasma-Enhanced Chemical Vapor Deposition*), l'épitaxie en phase vapeur aux hydrures (HVPE, pour *Hydride Vapor Phase Epitaxy*), voire également la pulvérisation cathodique réactive (*sputtering* en anglais). Des techniques telles que l'épitaxie par jets moléculaires (MBE, pour *Molecular-Beam Epitaxy*) ou l'épitaxie en phase liquide (LPE, pour *Liquid Phase Epitaxy*) peuvent également être utilisées.

La couche semiconductrice 10 est une couche épaisse, dans le sens où son épaisseur est supérieure à son épaisseur critique de relaxation plastique des contraintes mécaniques, de sorte qu'elle présente la zone inférieure z_{inf} contrainte en compression située au contact de la couche de nucléation 3 en germanium, et la zone supérieure zₛᵤₚ qui ne comporte sensiblement pas de défauts structuraux. La couche semiconductrice 10 de GeSn présente ici une épaisseur égale à 480nm environ. Par ailleurs, la proportion atomique d'étain x ici de 8% de la couche semiconductrice 10 présente une valeur au moins égale à une valeur minimale xₘᵢₙ, laquelle est prédéfinie et dépend de la valeur xₚₛ₂ que l'on souhaite obtenir dans les structures verticales 13.2, compte tenu de la contrainte en tension εₚₛ qui sera générée dans la portion supérieure 13. Cette valeur inférieure xₘᵢₙ peut être définie préalablement au moyen d'essais expérimentaux. Enfin, la couche semiconductrice 10 présente ici une épaisseur constante, et comporte deux faces sensiblement planes, une face inférieure au contact de la couche de nucléation 3, et la face supérieure 10a opposée.

En référence à la fig.3B, on réalise ici une structuration en épaisseur de la couche de nucléation 3 et de la couche semiconductrice 10, par des opérations de photolithographie et gravure. Il s'agit ici de graver la couche de nucléation 3 et la couche semiconductrice 10, pour former des portions de couche, selon une forme dans le plan XY qui dépend de la fonction optique de ces portions de couche. Par ailleurs, on peut également réaliser au moins une échancrure 20 au niveau de la face supérieure de manière à délimiter ce qui sera la région intrinsèque 15 de la jonction PIN. Par ailleurs, le ou les réflecteurs de Bragg (non représentés) peuvent être réalisés dans la couche de nucléation 3 en germanium ou dans la couche semiconductrice 10 en GeSn.

En référence à la fig.3C qui est une vue de dessus de l'empilement de la fig.3B, le substrat support 2 peut comporter un guide d'onde intégré (non représenté), et la couche de nucléation 3 et la couche semiconductrice 10 peuvent former des guides d'onde supérieurs couplés optiquement au guide d'onde intégré. Plus précisément, le guide d'onde de la couche semiconductrice 10 est couplé optiquement au guide d'onde intégré par le biais du guide d'onde 21 de la couche de nucléation 3. D'autres structurations sont bien sûr possibles.

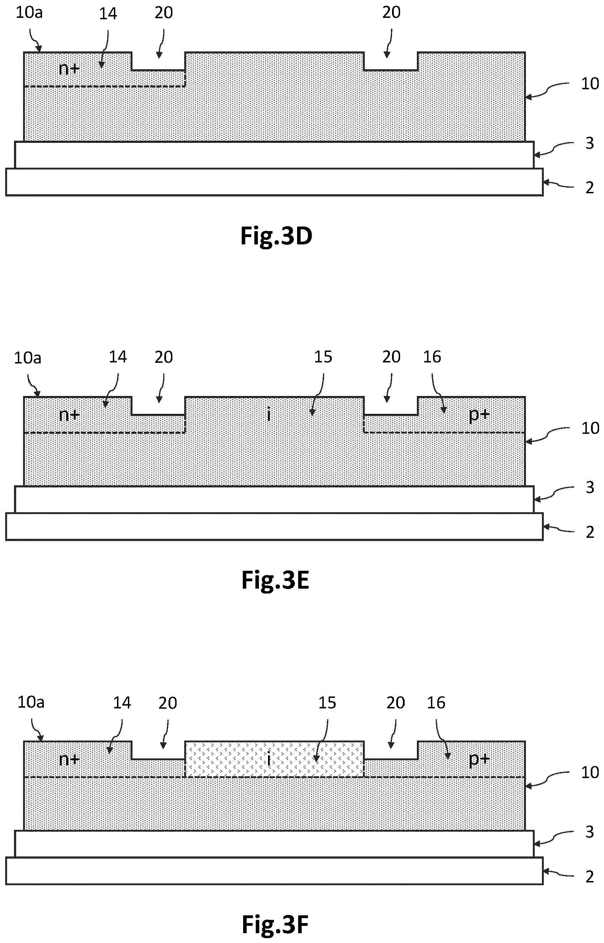

En référence à la fig.3D, on réalise l'une des régions dopées de la jonction PIN, ici la région 14 dopée n+. Le dopage est réalisé ici par implantation ionique d'espèces dopantes de type n, par exemple de phosphore, de manière localisée. La région 14 dopée n+ présente ici une profondeur de 135nm environ.

En référence à la fig.3E, on réalise l'autre des régions dopées de la jonction PIN, ici la région 16 dopée p+. Le dopage est réalisé ici par implantation ionique d'espèces dopantes de type p, par exemple de bore, de manière localisée. Les régions 14, 16 dopées n+ et p+ sont espacées l'une de l'autre dans le plan XY par la région intrinsèque 15 (non intentionnellement dopée). La région 14 dopée p+ présente ici aussi une épaisseur de 135nm environ. Un recuit de courte durée (*laser annealing* en anglais) peut être effectué pour activer les dopants des régions 14, 16 dopées n+ et p+.

En référence à la fig.3F, on réalise une amorphisation localisée d'une partie de la couche semiconductrice 10, ici dans la région intrinsèque 15. Cette étape est facultative et peut donc être omise. Cette amorphisation localisée est effectuée par implantation ionique d'éléments chimiques non dopants, par exemple ici du germanium ou du silicium. La profondeur d'amorphisation est de préférence au moins égale à la profondeur des régions 14, 16 dopées n+ et p+, et donc ici à 135nm environ.

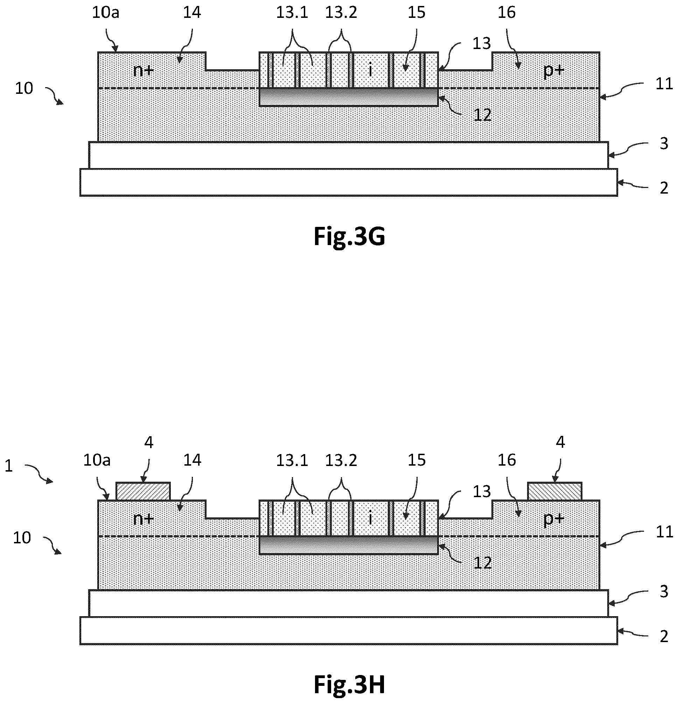

En référence à la fig.3G, on réalise la portion intermédiaire 12 et la portion supérieure 13, par recuit localisé par laser nanoseconde (NLA pour *Nanoseconde Laser Annealing* en anglais) d'une partie de la couche semiconductrice 10, et plus précisément de la partie rendue amorphe. Pour cela, la surface supérieure de la partie amorphe de la couche semiconductrice 10 est soumise à une impulsion laser présentant une longueur d'onde, une densité d'énergie minimale et une durée minimale prédéfinies de manière à provoquer la fusion totale de la partie amorphe sur toute sa profondeur et sur toute sa largeur, ainsi que la fusion totale d'une partie du GeSn monocristallin sous-jacent. L'impulsion laser présente une longueur d'onde adaptée à ce que l'impulsion laser soit absorbée au moins en partie par la couche semiconductrice 10, par exemple une longueur d'onde dans l'ultra-violet, par exemple égale à 308nm. Notons ici que la durée d'une impulsion laser est définie comme la largeur à mi-hauteur de l'évolution temporelle de l'intensité optique.

Par ailleurs, par fusion totale, on entend que le GeSn est entièrement fondu, et qu'il ne reste pas localement sous forme cristalline. Dans cet exemple, la fusion du GeSn est effectuée sur une profondeur supérieure à 135nm, par exemple sur une profondeur au moins égale à 150nm environ. A titre d'exemple, l'impulsion laser peut durer au moins quelques dizaines ou centaines de nanosecondes, par exemple au moins égale à 145ns (largeur à mi-hauteur de l'impulsion laser) et présenter une densité d'énergie au moins égale à une valeur qui dépend du matériau éclairé (composition chimique, état cristallin, état de surface et contraintes mécaniques, notamment). Ainsi, dans le cas où on souhaite appliquer l'impulsion laser sur la région 14 ayant été dopée n+ et amorphisée par implantation ionique de phosphore avec une dose de 3×10¹⁵ at/cm² avec une énergie égale à 50keV ou égale à 70keV, la densité d'énergie de l'impulsion laser peut être respectivement au moins égale à 0.7J/cm² ou à 0.8J/cm² pour obtenir une fusion totale du GeSn sur une profondeur d'au moins 150nm. Dans la variante où la portion supérieure 13 n'a pas été amorphisée par implantation ionique, la densité d'énergie de l'impulsion laser peut être au supérieure à 0,8 J/cm². Ces valeurs peuvent ainsi être adaptées pour obtenir une fusion totale de la portion de GeSn sur la profondeur voulue.

Lorsque le recuit par laser nanoseconde est terminé, une recristallisation du GeSn a lieu, avec un front de cristallisation qui se déplace à partir du GeSn monocristallin non fondu en direction de la face supérieure 10a. Il apparaît alors, d'une manière surprenante, que cela se traduit par la formation de la portion intermédiaire 12 où la proportion atomique d'étain chute jusqu'à la valeur minimale xₚᵢ₁, ici égale à 2% environ, et à la formation de la portion supérieure 13 qui est formée du milieu homogène 13.1 avec une proportion atomique d'étain xₚₛ₁ ici égale à 7% environ, sensiblement homogène et supérieure à xₚᵢ₁, dans lequel se trouve des structures verticales 13.2 avec une proportion atomique d'étain xₚₛ₂ ici égale à 16% environ, supérieure à xₚₛ₁. De plus, il apparaît que la portion supérieure 13 est monocristalline malgré la présence des structures verticales 13.2, et qu'elle présente une contrainte en tension d'une valeur εₚₛ ici égale à -0.4% environ. Ainsi, dans la portion supérieure 13, la contrainte en tension εₚₛ et la proportion atomique d'étain xₚₛ₁ sont telles que la structure de bandes d'énergie est directe, dans le milieu homogène 13.1 et *a fortiori* dans les structures verticales 13.2. De plus, la structure de bandes d'énergie dans la portion supérieure 13 (et donc dans la région intrinsèque 15) montre que les structures verticales 13.2 forment des puits quantiques adaptés à la génération du rayonnement infrarouge. Enfin, comme indiqué précédemment, dans la portion intermédiaire 12, la zone appauvrie en étain où la proportion atomique d'étain xₚᵢ₁ (ici 2% environ) est inférieure à xₚₛ₁ (ici 7% environ), forme une zone barrière qui s'étend sous toute la portion supérieure 13 et tend à confiner les porteurs de charge dans la portion supérieure 13 et donc dans la région intrinsèque 15.

En référence à la fig.3H, on réalise enfin les contacts métalliques 4, qui reposent sur la face supérieure de la couche semiconductrice 10, l'un au contact de la région 14 dopée n+ et l'autre au contact de la région 16 dopée p+. Ces contacts métalliques sont raccordés à une source électrique et permettent de polariser la diode laser.

Ainsi, le procédé permet de fabriquer un dispositif optoélectronique 1, ici une diode laser, où la couche semiconductrice 10 comporte une portion de base 11, une portion intermédiaire 12 dont une zone forme une zone barrière, et une portion supérieure 13 où se situe la région intrinsèque 15 et qui comporte des structures verticales 13.2 formant des puits quantiques. La portion supérieure 13 est monocristalline, contrainte en tension et présente une structure de bandes directe. On obtient donc un dispositif optoélectronique 1 présentant de bonnes performances pour l'émission ou la détection de lumière. Cette couche semiconductrice 10 à base de GeSn, avec ces portions intermédiaire 12 et supérieure 13, n'est donc pas réalisée par des techniques d'ingénierie des contraintes mécaniques ou par une technique de membrane suspendue et mise en tension et ensuite effondrée, comme dans les exemples de l'art antérieur mentionnés précédemment.

Notons que l'application d'un recuit par laser nanoseconde à une couche semiconductrice 10 à base de GeSn est décrit dans l'article de Gallucio et al. intitulé Cell formation on stanogermanides using pulsed laser thermal anneal on Ge0.91Sn0.09, Materials Science in Semiconductor Processing 121 (2021) 105399. Cependant, dans cet article, l'impulsion laser éclaire une couche de nickel qui recouvre la couche semiconductrice 10 de GeSn, et non pas directement cette dernière. Elle présente une densité d'énergie comprise entre 100 et 500 mJ/cm². Cette couche de nickel absorbe le rayonnement laser et assure une conversion thermique provoquant une fusion du GeSn sous-jacent. Si la formation de colonnes verticales riches en étain est observée, il n'y a pas décrit que la couche semiconductrice 10 est mise en tension de manière suffisante pour que la structure de bandes soit directe, ni qu'une portion intermédiaire sous-jacente appauvrie en étain ait été réalisée.

Selon un autre mode de réalisation, l'étape d'amorphisation (fig.3F) d'une partie de la couche semiconductrice 10, étant facultative, est omise. Aussi, après les étapes de réalisation des régions 14, 16 dopées n+ et p+, on peut procéder directement à l'étape de recuit par laser nanoseconde. Ce recuit peut être localisé et permet d'obtenir la structure globale illustrée sur la fig.3G. En variante, il peut être global, dans le sens où il est appliqué à l'ensemble de la face supérieure 10a de la couche semiconductrice 10, et permet d'obtenir une structure similaire à celle de la fig.4A. La densité d'énergie de l'impulsion laser de longueur d'onde à 308nm est alors adaptée, et peut être supérieure à 0,8/cm² environ, avec une durée d'au moins 145ns, pour obtenir une fusion totale du GeSn sur une profondeur au moins égale à 150nm environ.

A ce titre, la figure 4A est une vue partielle et schématique, en coupe transversale, d'un dispositif optoélectronique 1 selon une variante de réalisation. Le dispositif optoélectronique 1 se distingue ici de celui de la fig. 1A essentiellement en ce que le recuit par laser nanoseconde n'a pas été effectué de manière localisée, i.e. sur une surface précise de la face supérieure 10a, mais qu'il a été effectué sur toute la face supérieure 10a (les structures verticales 13.2 sont donc également présentes dans les régions dopées 14, 16). Ainsi, la portion intermédiaire 12 s'étend sur toute la largeur de la couche semiconductrice 10, et sépare verticalement la portion de base 11 de la portion supérieure 13. Les régions 14, 16 dopées n+ et p+ sont donc situées dans la portion supérieure 13 et non plus dans la portion de base 11. La zone barrière (appauvrie en étain) de la portion intermédiaire 12 s'étend donc sous la région 14 dopée n+, la région intrinsèque 15 et la région 16 dopée p+. Le dispositif optoélectronique 1 selon cette variante peut être réalisé par un procédé similaire à celui décrit en référence aux fig.3A à 3H (et qui s'en distingue par le fait que le recuit par laser nanoseconde a été fait sur toute la face supérieure 10a), le recuit par laser nanoseconde étant précédé ou non par une étape d'amorphisation.

A ce titre, la figure 4B est une vue partielle et schématique, en coupe transversale, d'un dispositif optoélectronique 1 selon une variante de réalisation. Le dispositif optoélectronique 1 est ici une diode laser, qui se distingue de celui de la fig.1A essentiellement en ce que l'une des régions dopées, ici la région 16 dopée p+ est située dans la portion supérieure 13, au-dessus de la région intrinsèque 15. Dans cet exemple, la région 14 dopée n+ est située de part et d'autre, dans le plan XY, de la région intrinsèque 15 et de la région 16 dopée p+. Elle est située dans la portion de base 11 (configuration de la fig.1A), mais en variante, elle pourrait être située dans la portion supérieure 13 (configuration de la fig.4A). La région 16 dopée p+ est formée d'une zone supérieure de la portion supérieure 13 qui affleure la face supérieure 10a. Un contact métallique 4 repose donc sur et au contact de la région 16 dopée p+ de la portion supérieure 13. Par ailleurs, dans cet exemple, la couche semiconductrice 10 ne comporte pas nécessairement d'échancrure délimitant dans le plan XY la portion supérieure 13 et ici la région intrinsèque 15 et la région 16 dopée p+.

Des modes de réalisation particuliers viennent d'être décrits. Différentes variantes et modifications apparaîtront à l'homme du métier.

## Revendications

1. Dispositif optoélectronique (1) d'émission ou de réception d'un rayonnement infrarouge, comportant :
∘ une couche de nucléation (3) ;
∘ une couche semiconductrice (10) cristalline à base de GeSn, s'étendant suivant un plan principal, présentant une face supérieure (10a) opposée à la couche de nucléation (3), et comportant :
• une portion de base (11), s'étendant sur et au contact de la couche de nucléation ;
• une portion supérieure (13), s'étendant sur la portion de base (11), monocristalline, et contrainte en tension d'une valeur moyenne εₚₛ dans le plan principal, formée d'un milieu homogène (13.1), présentant une valeur homogène xₚₛ₁ de proportion atomique d'étain, la valeur moyenne εₚₛ des contraintes en tension et la valeur xₚₛ₁ de la proportion atomique d'étain étant telles que la portion supérieure (13) présente une structure de bandes interdites directe ;
• une jonction semiconductrice PIN, comportant une région (14) dopée de type n, et une région (16) dopée de type p, affleurant la face supérieure (10a), et une région intrinsèque (15), située dans la portion supérieure (13), et s'étendant entre les régions dopées (14, 16) ;
∘ des contacts métalliques (4) de polarisation, situés sur et au contact des régions dopées (14, 16) ;
∘ **caractérisé en ce que** :
• la portion supérieure (13) monocristalline comporte, outre le milieu homogène (13.1), des structures verticales (13.2) s'étendant dans le milieu homogène (13.1) suivant un axe orthogonal au plan principal sur toute l'épaisseur de la portion supérieure (13), et présentant une valeur moyenne xₚₛ₂ de proportion atomique d'étain supérieure à xₚₛ₁, formant ainsi des zones d'émission ou de réception du rayonnement infrarouge ;
• la couche semiconductrice (10) comporte en outre une portion intermédiaire (12), située entre et au contact de la portion de base (11) et la portion supérieure (13) suivant un axe orthogonal au plan principal, monocristalline, et comportant une zone s'étendant dans le plan principal sur toute sa largeur et présentant une valeur moyenne xₚᵢ₁ de proportion atomique d'étain inférieure à xₚₛ₁, formant ainsi une zone barrière vis-à-vis de porteurs de charge circulant dans la portion supérieure (13).

2. Dispositif optoélectronique (1) selon la revendication 1, dans lequel la portion de base (11) présente une valeur moyenne x_{pb} supérieure à la valeur moyenne xₚᵢ₁ de la proportion atomique d'étain dans la portion intermédiaire (12) et inférieure à la valeur moyenne xₚₛ₂ de la proportion atomique d'étain dans les structures verticales (13.2).

3. Dispositif optoélectronique (1) selon la revendication 2, dans lequel la valeur moyenne x_{pb} de la proportion atomique d'étain dans la portion de base (11) est comprise entre 4% et 10%.

4. Dispositif optoélectronique (1) selon l'une quelconque des revendications 1 à 3, dans lequel la portion de base (11) s'étend jusqu'à une surface de la face supérieure (10a), et entoure la portion intermédiaire (12) et la portion supérieure (13) dans le plan principal, au moins l'une des régions dopées (14 ; 16) étant situées dans la portion de base (11).

5. Dispositif optoélectronique (1) selon l'une quelconque des revendications 1 à 3, dans lequel la portion intermédiaire (12) recouvre entièrement la portion de base (11), les régions dopées (14, 16) étant situées dans la portion supérieure (13).

6. Dispositif optoélectronique (1) selon l'une quelconque des revendications 1 à 5, dans lequel la couche semiconductrice est formée, à partir de la couche de nucléation (3), d'une zone inférieure (z_{inf}) et d'une zone supérieure (zₛᵤₚ) monocristalline qui recouvre la zone inférieure (z_{inf}), la portion supérieure (13) étant située dans la zone supérieure (zₛᵤₚ).

7. Dispositif optoélectronique (1) selon l'une quelconque des revendications 1 à 6, dans lequel la couche de nucléation (3) est réalisée en germanium, et repose sur un substrat support (2) de préférence à base de silicium.

8. Dispositif optoélectronique (1) selon l'une quelconque des revendications 1 à 7, formant une diode laser ou une diode électroluminescente adaptée à générer le rayonnement infrarouge, ou une photodiode adaptée à détecter le rayonnement infrarouge.

9. Dispositif optoélectronique (1) selon l'une quelconque des revendications 1 à 7, formant une diode laser, comportant un guide d'onde dit inférieur réalisé dans la couche de nucléation (3) à base de germanium, un guide d'onde dit actif couplé au guide d'onde inférieur, comportant le milieu à gain et réalisé dans la couche semiconductrice (10), et au moins un réflecteur de Bragg situé dans le guide d'onde inférieur ou dans le guide d'onde actif.

10. Procédé de fabrication d'un dispositif optoélectronique selon l'une quelconque des revendications précédentes, comportant les étapes suivantes :
∘ réalisation de la couche semiconductrice (10) présentant une valeur initiale homogène de la proportion atomique d'étain, égale à la valeur moyenne x_{pb} de la portion de base (11), par épitaxie à partir de la couche de nucléation (3) ;
∘ réalisation des régions dopées (14, 16) dans la couche semiconductrice (10), espacées l'une de l'autre par la région intrinsèque (15) ;
∘ réalisation de la portion intermédiaire (12) et de la portion supérieure (13), par recuit par laser nanoseconde, en appliquant une impulsion laser sur au moins une surface de la face supérieure (10a) où affleure la région intrinsèque (15), présentant une longueur d'onde, une densité d'énergie et une durée prédéfinies de manière à faire fondre entièrement une partie du composé de la couche semiconductrice (10) sur une profondeur prédéfinie de celle-ci, de préférence au moins égale à 150nm.

11. Procédé de fabrication selon la revendication 10, dans lequel l'étape de recuit par laser nanoseconde est effectuée en éclairant par l'impulsion laser seulement la surface de la face supérieure (10a) où affleure la région intrinsèque (15).

12. Procédé de fabrication selon la revendication 10, dans lequel l'étape de recuit par laser nanoseconde est effectuée en éclairant par l'impulsion laser la face supérieure (10a) de la couche semiconductrice (10) où se situe la jonction semiconductrice PIN.

13. Procédé de fabrication selon l'une quelconque des revendications 10 à 12, comportant, préalablement à l'étape de recuit par laser nanoseconde, une étape d'amorphisation d'au moins la région intrinsèque (15) par implantation ionique d'élément chimiques non dopants de type n ou p, sur une profondeur au moins égale à la profondeur des régions dopées (14, 16).

14. Procédé de fabrication selon la revendication 11 et 13, dans lequel seule la région intrinsèque (15) est amorphisée lors de l'étape d'amorphisation, avant l'étape de recuit par laser nanoseconde.

15. Procédé de fabrication selon la revendication 12 et 13, dans lequel l'étape de réalisation des régions dopées (14, 16) est effectuée de manière à amorphiser les régions dopées (14, 16).

## Patentansprüche

1. Optoelektronische Vorrichtung (1) zum Senden oder Empfangen von Infrarotstrahlung, beinhaltend:
∘ eine Keimbildungsschicht (3);
∘ eine kristalline Halbleiterschicht (10) auf der Basis von GeSn, die sich entlang einer Hauptebene erstreckt und eine obere Seite (10a) aufweist, die der Keimbildungsschicht (3) gegenüberliegt, und beinhaltet:
• einen Basisabschnitt (11), der sich über und in Kontakt mit der Keimbildungsschicht erstreckt;
• einen oberen Abschnitt (13), der sich über dem Basisabschnitt (11) erstreckt, monokristallin, und spannungsbeansprucht mit einem Mittelwert εₚₛ in der Hauptebene ist, gebildet aus einem homogenen Medium (13.1), das einen homogenen Wert xₚₛ₁ des Atomverhältnisses des Zinns aufweist, wobei der Mittelwert εₚₛ der Spannungsbeanspruchung und der Wert xₚₛ₁ des Atomverhältnisses des Zinns derart sind, dass der obere Abschnitt (13) eine Struktur mit direkten Bandlücken aufweist;
• einen halbleitenden Übergang PIN, einen Bereich (14) beinhaltend, der mit dem n-Typ dotiert ist, und einen Bereich (16), der mit dem p-Typ dotiert ist, der bündig mit der oberen Seite (10a) ist, und einen intrinsischen Bereich (15), der sich im oberen Abschnitt (13) befindet und sich zwischen den dotierten Bereichen (14, 16) erstreckt;
o Metallkontakte (4) zur Polarisation, die sich über und in Kontakt mit den dotierten Bereichen (14, 16) befinden;
o **dadurch gekennzeichnet, dass**:
• der monokristalline obere Abschnitt (13) beinhaltet, neben dem homogenen Medium (13.1), vertikale Strukturen (13.2), die sich im homogenen Medium (13.1) entlang einer Achse orthogonal zur Hauptebene über die gesamte Dicke des oberen Abschnitts (13) erstrecken, und einen Mittelwert xₚₛ₂ des Atomverhältnisses des Zinns aufweisen, der größer ist als xₚₛ₁, und Zonen für die Sendung oder den Empfang von Infrarotstrahlung bildet;
• die Halbleiterschicht (10) ferner einen Zwischenabschnitt (12) beinhaltet, der sich zwischen und in Kontakt mit dem Basisabschnitt (11) und dem oberen Abschnitt (13) befindet, und einer Achse orthogonal zur Hauptebene folgt, monokristallin, und eine Zone beinhaltet, die sich in der Hauptebene über seine gesamte Breite erstreckt, und einen Mittelwert xₚᵢ₁ des Atomverhältnisses des Zinns aufweist, der kleiner als xₚₛ₁ ist, und eine Sperrzone gegenüber den Ladungsträgern bildet, die im oberen Abschnitt (13) zirkulieren.

2. Optoelektronische Vorrichtung (1) nach Anspruch 1, wobei der Basisabschnitt (11) einen Mittelwert x_{pb} aufweist, der größer ist als der Mittelwert xₚᵢ₁ des Atomverhältnisses des Zinns im Zwischenabschnitt (12) und kleiner als der Mittelwert xₚₛ₂ des Atomverhältnisses des Zinns in den vertikalen Strukturen (13.2).

3. Optoelektronische Vorrichtung (1) nach Anspruch 2, wobei der Mittelwert x_{pb} des Atomverhältnisses des Zinns im Basisabschnitt (11) zwischen 4 % und 10 % liegt.

4. Optoelektronische Vorrichtung (1) nach einem der Ansprüche 1 bis 3, wobei sich der Basisabschnitt (11) bis zu einer Oberfläche der oberen Seite (10a) erstreckt und den Zwischenabschnitt (12) und den oberen Abschnitt (13) in der Hauptebene umgibt, wobei sich mindestens einer der dotierten Bereiche (14; 16) im Basisabschnitt (11) befindet.

5. Optoelektronische Vorrichtung (1) nach einem der Ansprüche 1 bis 3, wobei der Zwischenabschnitt (12) den Basisabschnitt (11) vollständig bedeckt, und sich die dotierten Bereiche (14, 16) im oberen Abschnitt (13) befinden.

6. Optoelektronische Vorrichtung (1) nach einem der Ansprüche 1 bis 5, wobei die Halbleiterschicht, ausgehend von der Keimbildungsschicht (3), aus einer unteren Zone (z_{inf}) gebildet ist und einer monokristallinen oberen Zone (zₛᵤₚ), die die untere Zone (z_{inf}) bedeckt, wobei sich der obere Abschnitt (13) in der oberen Zone (zₛᵤₚ) befindet.

7. Optoelektronische Vorrichtung (1) nach einem der Ansprüche 1 bis 6, wobei die Keimbildungsschicht (3) aus Germanium erstellt ist, und auf einem Trägersubstrat (2) ruht, vorzugsweise auf Siliziumbasis.

8. Optoelektronische Vorrichtung (1) nach einem der Ansprüche 1 bis 7, eine Laserdiode bildend oder eine Leuchtdiode, die geeignet ist, Infrarotstrahlung zu erzeugen oder eine Fotodiode, die geeignet ist, Infrarotstrahlung zu erkennen.

9. Optoelektronische Vorrichtung (1) nach einem der Ansprüche 1 bis 7, eine Laserdiode bildend, die einen Wellenleiter, unterer genannt, beinhaltet, der in der Keimbildungsschicht (3) auf Germaniumbasis erstellt ist, einen Wellenleiter, aktiv genannt, der mit dem unteren Wellenleiter gekoppelt ist, das Verstärkungsmedium beinhaltend, und in der Halbleiterschicht (10) erstellt ist, und mindestens einen Bragg-Spiegel, der sich im unteren Wellenleiter oder im aktiven Wellenleiter befindet.

10. Verfahren zur Herstellung einer optoelektronischen Vorrichtung nach einem der vorhergehenden Ansprüche, die folgenden Schritte beinhaltend:
o Erstellen der Halbleiterschicht (10), die einen homogenen Anfangswert des Atomverhältnisses des Zinns aufweist, der gleich dem Mittelwert x_{pb} des Basisabschnitts (11) ist, durch Epitaxie ausgehend von der Keimbildungsschicht (3);
o Erstellen der dotierten Bereiche (14, 16) in der Halbleiterschicht (10), die durch den intrinsischen Bereich (15) voneinander beabstandet sind;
o Erstellen des Zwischenabschnitts (12) und des oberen Abschnitts (13), durch Glühen mit einem Nanosekundenlaser, durch Anlegen eines Laserimpulses auf mindestens eine Oberfläche der oberen Seite (10a), die bündig mit dem intrinsischen Bereich (15) ist, und eine vordefinierte Wellenlänge, Energiedichte und Dauer aufweist, um einen Teil der Verbindung der Halbleiterschicht (10) bis zu einer vordefinierten Tiefe davon vollständig zu schmelzen, vorzugsweise mindestens 150 nm.

11. Herstellungsverfahren nach Anspruch 10, wobei der Schritt des Glühens mit einem Nanosekundenlaser durchgeführt wird, indem mit dem Laserimpuls nur die Oberfläche der oberen Seite (10a), die bündig mit dem intrinsischen Bereich (15) ist, bestrahlt wird.

12. Herstellungsverfahren nach Anspruch 10, wobei der Schritt des Glühens mit einem Nanosekundenlaser durchgeführt wird, indem mit dem Laserimpuls die obere Seite (10a) der Halbleiterschicht (10), an der sich der halbleitende Übergang PIN befindet, bestrahlt wird.

13. Herstellungsverfahren nach einem der Ansprüche 10 bis 12, beinhaltend, vor dem Schritt des Glühens mit einem Nanosekundenlaser, einen Schritt des Amorphisierens mindestens des intrinsischen Bereichs (15) durch lonenimplantation eines chemischen nicht dotierenden Elements vom n- oder p-Typ, in einer Tiefe, die mindestens der Tiefe der dotierten Bereiche (14, 16) entspricht.

14. Herstellungsverfahren nach Anspruch 11 und 13, wobei nur der intrinsische Bereich (15) während des Amorphisierungsschritts amorphisiert wird, vor dem Schritt des Glühens mit einem Nanosekundenlaser.

15. Herstellungsverfahren nach Anspruch 12 und 13, wobei der Erstellungsschritt der dotierten Bereiche (14, 16) durchgeführt wird, um die dotierten Bereiche (14, 16) zu amorphisieren.

## Claims

1. An optoelectronic device (1) for emitting or receiving infrared radiation, including:
- a nucleation layer (3);
- a crystalline semiconductor layer (10) based on GeSn, extending along a main plane, having an upper face (10a) opposite the nucleation layer (3), and including:
- a base portion (11), extending over and in contact with the nucleation layer;
- an upper portion (13), extending over the base portion (11), which is monocrystalline, and tensile stressed by an average value εₚₛ in the main plane, formed of a homogeneous medium (13.1), having a homogeneous value xₚₛ₁ of tin atomic proportion, the average value εₚₛ of the tensile stresses and the value xₚₛ₁ of the tin atomic proportion being such that the upper portion (13) has a direct bandgap structure;
- a semiconductor junction PIN, including an n-type doped region (14), and a p-type doped region (16), flush with the upper face (10a), and an intrinsic region (15), located in the upper portion (13), and extending between the doped regions (14, 16);
- metallic polarisation contacts (4), located on and in contact with the doped regions (14, 16);
- **characterised in that**:
- the monocrystalline upper portion (13) includes, in addition to the homogeneous medium (13.1), vertical structures (13.2) extending in the homogeneous medium (13.1) along an axis orthogonal to the main plane over the entire thickness of the upper portion (13), and having an average value xₚₛ₂ of tin atomic proportion greater than xₚₛ₁, thus forming areas of emission or reception of infrared radiation;
- the semiconductor layer (10) further includes an intermediate portion (12), located between and in contact with the base portion (11) and the upper portion (13) along an axis orthogonal to the main plane, which is monocrystalline, and including an area extending in the main plane over its entire width and having an average value xₚᵢ₁ of tin atomic proportion less than xₚₛ₁, thus forming a barrier area with respect to charge carriers circulating in the upper portion (13).

2. The optoelectronic device (1) according to claim 1, wherein the base portion (11) has an average value x_{pb} greater than the average value xₚᵢ₁ of the tin atomic proportion in the intermediate portion (12) and less than the average value xₚₛ₂ of the tin atomic proportion in vertical structures (13.2).

3. The optoelectronic device (1) according to claim 2, wherein the average value x_{pb} of the tin atomic proportion in the base portion (11) is comprised between 4% and 10%.

4. The optoelectronic device (1) according to any one of claims 1 to 3, wherein the base portion (11) extends to a surface of the upper face (10a), and surrounds the intermediate portion (12) and the upper portion (13) in the main plane, at least one of the doped regions (14; 16) being located in the base portion (11).

5. The optoelectronic device (1) according to any one of claims 1 to 3, wherein the intermediate portion (12) completely covers the base portion (11), the doped regions (14, 16) being located in the upper portion (13).

6. The optoelectronic device (1) according to any one of claims 1 to 5, wherein the semiconductor layer is formed, from the nucleation layer (3), of a lower area (z_{inf}) and of an upper monocrystalline area (zₛᵤₚ) which covers the lower area (z_{inf}), the upper portion (13) being located in the upper area (zₛᵤₚ).

7. The optoelectronic device (1) according to any one of claims 1 to 6, wherein the nucleation layer (3) is made of germanium, and rests on a support substrate (2) preferably based on silicon.

8. The optoelectronic device (1) according to any one of claims 1 to 7, forming a laser diode or a light-emitting diode adapted to generate infrared radiation, or a photodiode adapted to detect infrared radiation.

9. The optoelectronic device (1) according to any one of claims 1 to 7, forming a laser diode, including a waveguide called lower waveguide made in the nucleation layer (3) based on germanium, a waveguide called active waveguide coupled to the lower waveguide, including the gain medium and produced in the semiconductor layer (10), and at least one Bragg reflector located in the lower waveguide or in the active waveguide.

10. A method for manufacturing an optoelectronic device according to any one of the preceding claims, including the following steps:
- producing the semiconductor layer (10) having a homogeneous initial value of the tin atomic proportion, equal to the average value x_{pb} of the base portion (11), by epitaxy from the nucleation layer (3);
- producing doped regions (14, 16) in the semiconductor layer (10), spaced from one another by the intrinsic region (15);
- producing the intermediate portion (12) and the upper portion (13), by nanosecond laser annealing, by applying a laser pulse to at least one surface of the upper face (10a) where the intrinsic region (15) is flush, having a predefined wavelength, energy density and duration so as to completely melt a part of the compound of the semiconductor layer (10) over a predefined depth thereof, preferably at least equal to 150nm.

11. The manufacturing method according to claim 10, wherein the nanosecond laser annealing step is carried out by illuminating with the laser pulse only the surface of the upper face (10a) where the intrinsic region (15) is flush.

12. The manufacturing method according to claim 10, wherein the nanosecond laser annealing step is carried out by illuminating with the laser pulse the upper face (10a) of the semiconductor layer (10) where the semiconductor junction PIN is located.

13. The manufacturing method according to any one of claims 10 to 12, including, prior to the nanosecond laser annealing step, a step of amorphisation of at least the intrinsic region (15) by ionic implantation of an n or p type non-doping chemical element, over a depth at least equal to the depth of the doped regions (14, 16).

14. The manufacturing method according to claims 11 and 13, wherein only the intrinsic region (15) is amorphised during the amorphisation step, before the nanosecond laser annealing step.

15. The manufacturing method according to claim 12 and 13, wherein the step of producing the doped regions (14, 16) is carried out so as to amorphise the doped regions (14, 16).
